# EUROPEAN PATENT SPECIFICATION

(11) **EP 0 657 966 B1**
(45) Date of publication and mention of the grant of the patent: **16.09.1998**
(21) Application number: 94308733.8
(22) Date of filing: 25.11.1994
(51) Int. Cl.: H01R 13/436, H01R 23/72

(54) **Electrical pin field**
Elektrisches Stiftfeld
Réseau broches électriques

(30) Priority: 13.12.1993 GB 9325421
(43) Date of publication of application: 14.06.1995
(60) Divisional application: 98200499.6
(73) Proprietor: THE WHITAKER CORPORATION, Wilmington, Delaware 19808 (US)
(72) Inventor: Soes, Lucas, NL-5248 BB Rosmalen (NL); Broeksteeg, Johannus Marcelus, NL-5341 AG Oss (NL)
(74) Representative: Warren, Keith Stanley

(56) References cited:
- EP-A- 0 138 368
- EP-A- 0 195 955
- EP-A- 0 273 589
- EP-A- 0 428 259
- EP-A- 0 578 487
- DE-U- 8 427 749

## Description

The present invention relates to an electrical pin field inserted in a printed circuit board with back-to-back headers positioned on opposite sides of the printed circuit board.

It is well known to form a pin field in printed circuit boards. These pins would be electrically connected to circuit traces in a printed circuit board, by way of press fit, for example, by way of compliant pin portions within the printed circuit board through hole. Extending in opposite directions from the compliant pins, are pin portions profiled for mating with complementary terminals in a complementary connector. Housings are positioned over the pins on opposite sides of the printed circuit boards to form a completed connector assembly. A difficulty which has arisen, is the method of retaining the housings to the pin field.

The printed circuit boards of the subject pin fields may have through holes having a diameter as small as 0.55 mm. Thus, the pin has on one side of the compliant pin portion, an enlarged barb, which is larger than the nominal width of the pin, which is profiled for interference fit within the corresponding housing. However, as the pin must be inserted through the printed circuit board through hole, the side of the pin opposite the entry side of the printed circuit board cannot contain a retaining barb, as it would not fit through the printed circuit board. Therefore, on one side of the printed circuit board, the pin is of a constant width, sometimes as narrow as 0.50 mm. The housings which enclose these pins generally have passageways which are interference fit with the pins.

One of the drawbacks to this approach is that, as the housings are inserted over the pin field, the housings interfere with the pin field and leave some of the plastic on the pins themselves which could lead to an unstable contact, as the plastic is directly on the contact surfaces. Thus, as the mating contact receptacle could have plastic particles between the contact surfaces and the pin itself, an ineffective contact could be made. Secondly, as many housings are made from glass filled housings, the glass particles in the housing could actually skive through the gold plating on the contacts, again leading to an ineffective contact system.

Our prior application EP-A-0 578 487, which is relevant under Art. 54(3) EPC, describes an electrical pin field which alleviates the drawbacks discussed above. It describes an electrical pin field comprising a printed circuit board having a plurality of pins extending between both sides thereof to position pin contact portions on opposite sides of the board , and insulating housings mounted over the pins on both sides of the board, in which at least one of the housings includes a locking plate medially positioned between the board and the housing. The locking plate has a plurality of through holes for receiving the pins and at least one gripping arm extending towards the housing, adjacent to each through hole. The gripping arms are interference fits with passageways in the housing and are positioned against the pin portions.

The present invention relates to a modification of the pin field described in our earlier application in which the housing having the locking plate, and hence the passageways in the housing, are positioned between the locking plate and the board.

In order that the present invention may be more readily understood, reference will now be made to the accompanying drawings, in which:-
Figure 1 is a cross-sectional view of the electrical pin field described in our prior application EP-A-0 578 487 and shows a first housing or header mounted to the lower side of a printed circuit board with the spacer member and second housing or header poised for receipt over the pin field;
Figure 2 is a top view of the locking plate of Figure 1;
Figure 3 is a side view of the locking plate;
Figure 4 is a lower plan view of the locking plate;
Figure 5 is a cross-sectional view through lines 5-5 of Figure 4;
Figure 6 is a plan view of a portion of the electrical pins used for the pin field;
Figure 7 is a view similar to that of Figure 1 showing the initial reception over the header of the spacer plate;

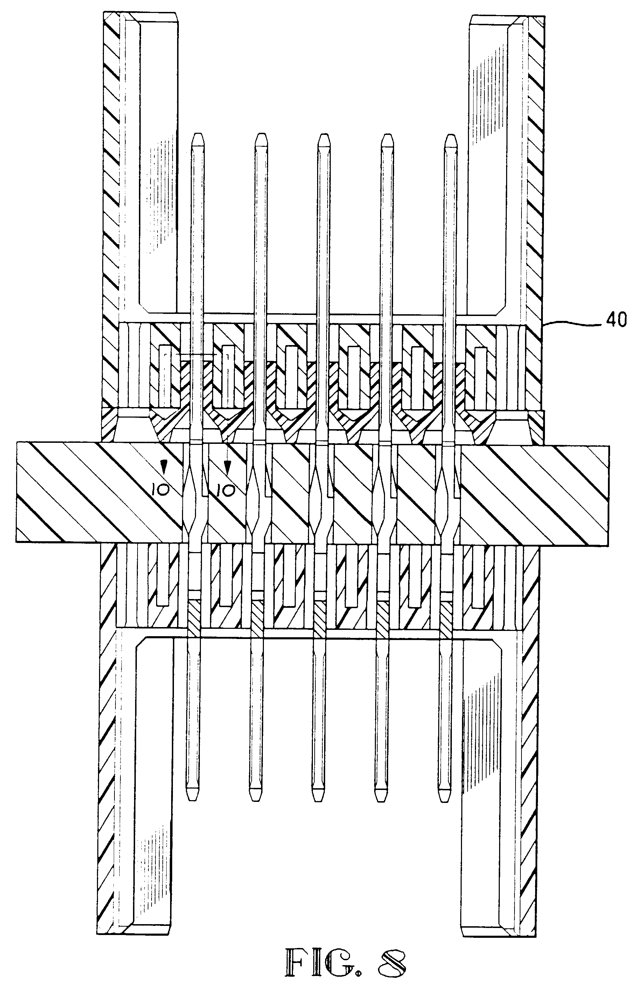

Figure 8 is a view similar to that of Figure 7 showing the fully assembled spacer plate and header of the pin field;
Figure 9 is a cross-sectional view through lines 9-9 of Figure 7;
Figure 10 is a cross-sectional view through lines 10-10 of Figure 8;
Figure 11 shows an upper header embodying the present invention and, which can be used with the lower header and pin field of Figure 1;
Figure 12 is a cross-sectional view through lines 12-12 of Figure 11; and
Figure 13 is a side view of the header shown in Figure 11.

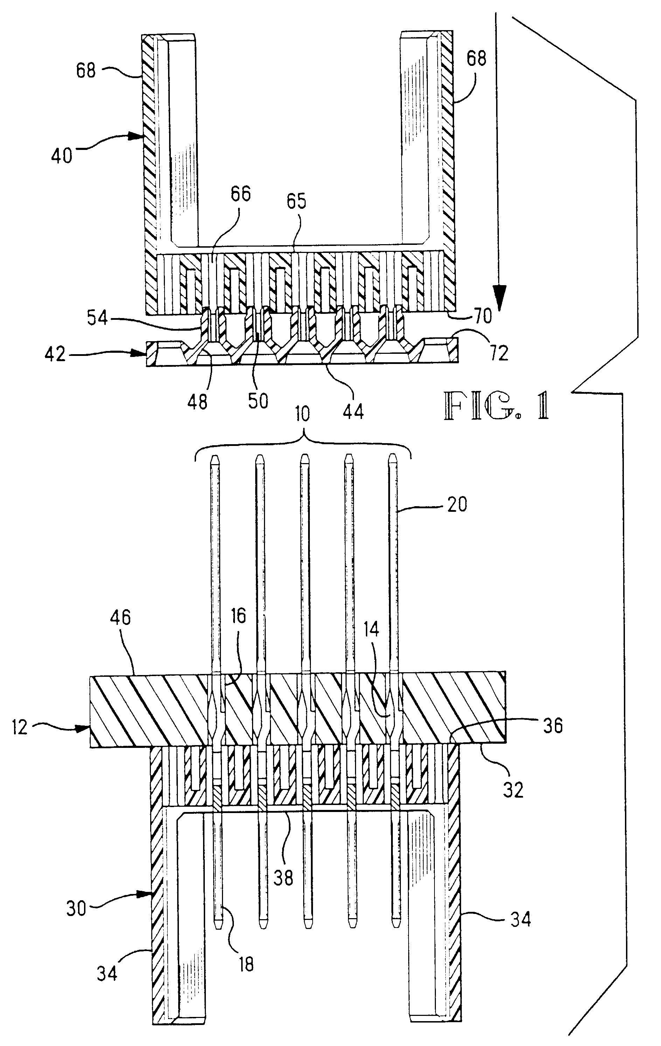

With reference first to Figure 1, the electrical pin field of our prior application comprises a plurality of pins 10 positioned on the printed circuit board 12, the pins being retained in position on the printed circuit board by compliant portions 14 on the pins inserted into through-holes 16 on the printed circuit board. The pins 10 generally include contact portions 18 on one side of the printed circuit board and contact portions 20 on the opposite side, the contact portions 18 and 20 being profiled for receiving complementary plug connectors in electrical engagement.

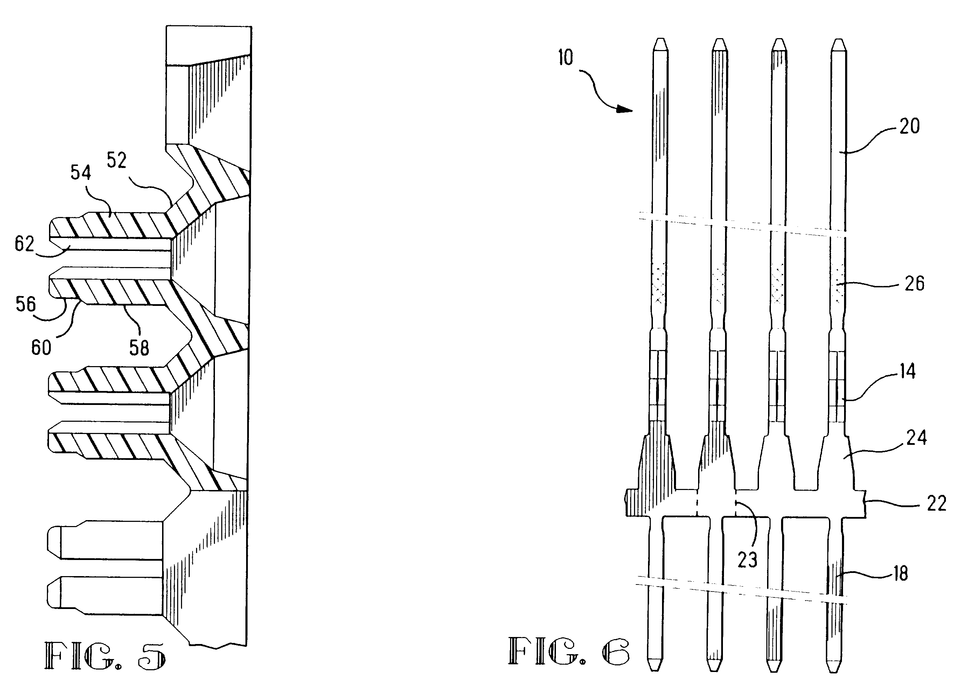

With respect now to Figure 6, the electrical pins 10 are shown as they are formed on a carrier strip such as 22 for reeling, or for assembly purposes with the electrical housings. The pins 10 will be sheared from the carrier strip 22 at phantom lines 23 for end use. The compliant portions are shown generally at 14 with enlarged portions shown at 24 which will be used for retaining the pin terminals within their respective housings, as will be described in greater detail herein. The contact portions 20 are shown above the compliant portion 14 whereas the compliant portions 18 are shown positioned below the compliant portions 14. The surfaces at 26 are roughened to provide a greater frictional surface.

With reference again to Figure 1, a housing member 30, made from an insulating material, is positioned over the contact portions 18 of the pins 10 to form a header assembly on the lower side 32 of the printed circuit board 12. This header assembly could be similar to that shown in EP-A-0 422 785. The housing 30 generally comprises upstanding sidewalls 34 on either side thereof which provides an opening for a complementary plug connector which could either be shielded or unshielded. With reference again to Figure 6, it should be noted that the enlarged portions 24 of the pins 10 are positioned medially of the contact portions 18 and the compliant pin portions 14. The insulating housing 30 is profiled to receive the contact portions 18 from a rear side 36 of the housing 30.

The pins 10 can either be positioned in the printed circuit board 12, and then later receive the housing 30 thereover such that the housing 30 is positioned with the mounting face 36 facing the surface 32 of the printed circuit board and then forced against the printed circuit board. Alternatively, the pins 10 could be forced into the housing 30 and the header assembly comprising the housing 30 and the pins 10 could be placed against the lower side 32 of the printed circuit board 30. In either case, it should be appreciated that the enlarged portions 24 of the pins 10 prevent removal of the housing over the pins, the housing 30 being profiled to receive the enlarged portions 24 therein.

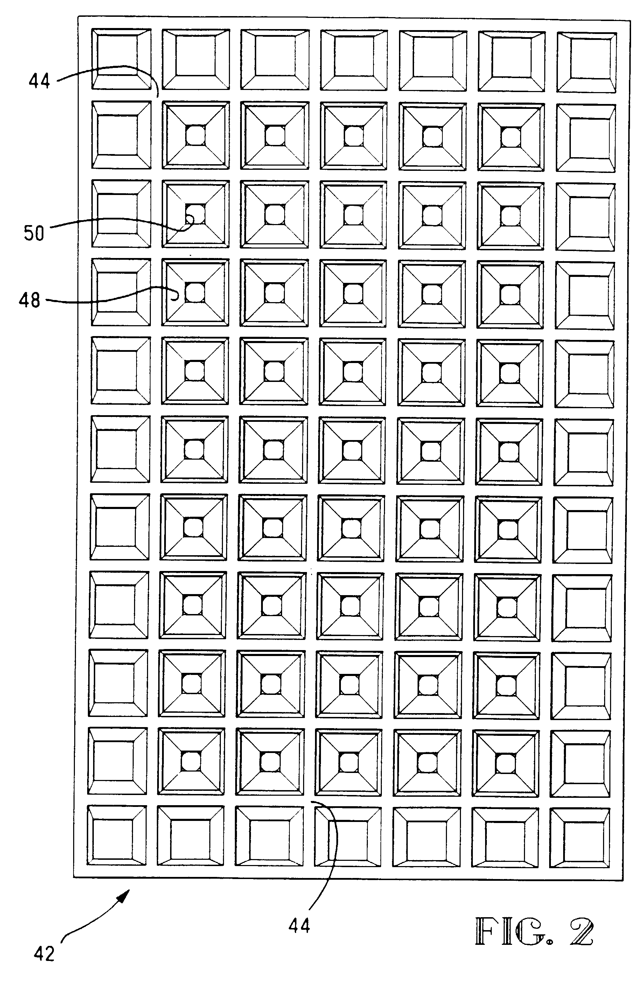

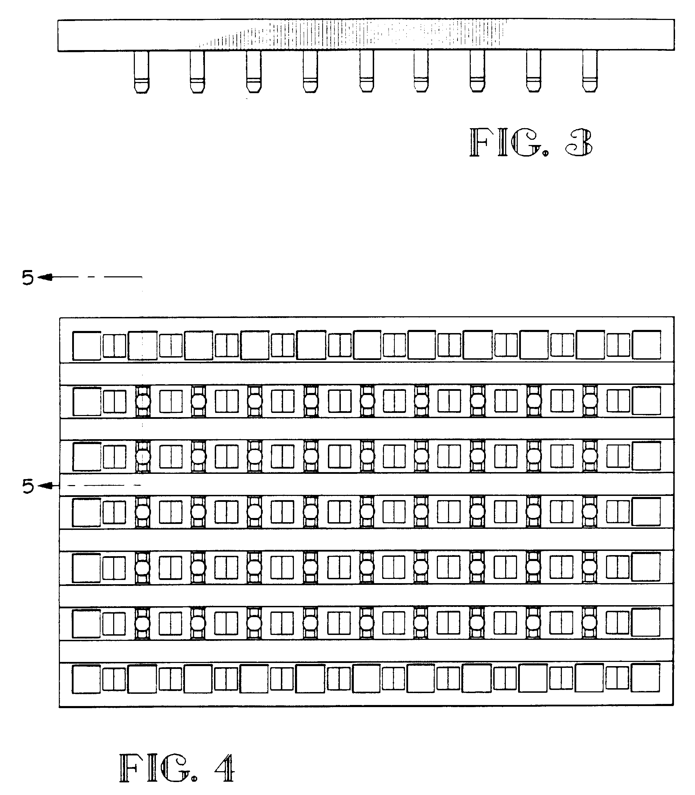

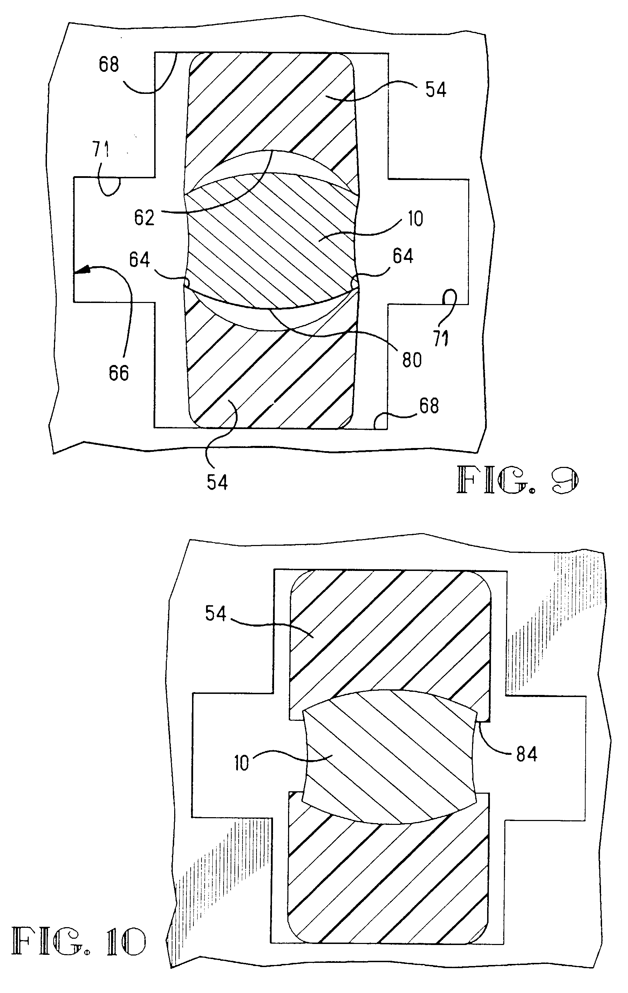

The pins 10 are profiled to be received in a printed circuit board through hole having a 0.55 mm diameter. Therefore, as the pins must pass through the printed circuit board, with the contact portion 20 leading, this prevents having an enlarged portion similar to 24 on the opposite side of the compliant pin portion 14 for retaining another housing thereto. Hence, this other housing is retained in position by a locking spacer plate or member 42. As shown best in Figure 2, the locking plate 42 has a lower face at 44 which is profiled for receipt against an upper surface 46 of the printed circuit board 12. It includes a plurality of lead-in openings 48 for easy placement of the locking spacer member 42 over the pin field at 10. Movement of the plate 42 over the pin field, centers each of the pins 10 with a central throughhole 50 in the spacer plate 42. As shown best in Figures 3-5, the spacer plate 42 has an opposite surface 52 including gripping or locking arms 54 extending from opposite sides of the opening 50. As shown best in Figure 5, the locking arms 54 include thin portions 56 adjacent to the distal end thereof and thickened portions 58 defined through a transition section 60. Also with reference to Figure 5 and 9, the surface facing the pins 10 has a cylindrical surface 62 forming outer tip surfaces at 64.

With reference again to Figure 1, the housing member 40 is similar in nature to the housing member 30, including a central section at 65 having a plurality of terminal passageways at 66 and sidewalls at 68 for receiving a complementary plug member. The housing member 40 further includes a lower mounting surface 70 which can be placed against a mounting surface 72 of the spacer member 42 when in the final position. As best shown in Figure 9, the housing passageways 66 are cruciform in configuration including end portions 68 which receive the locking arms 54 and side portions 71.

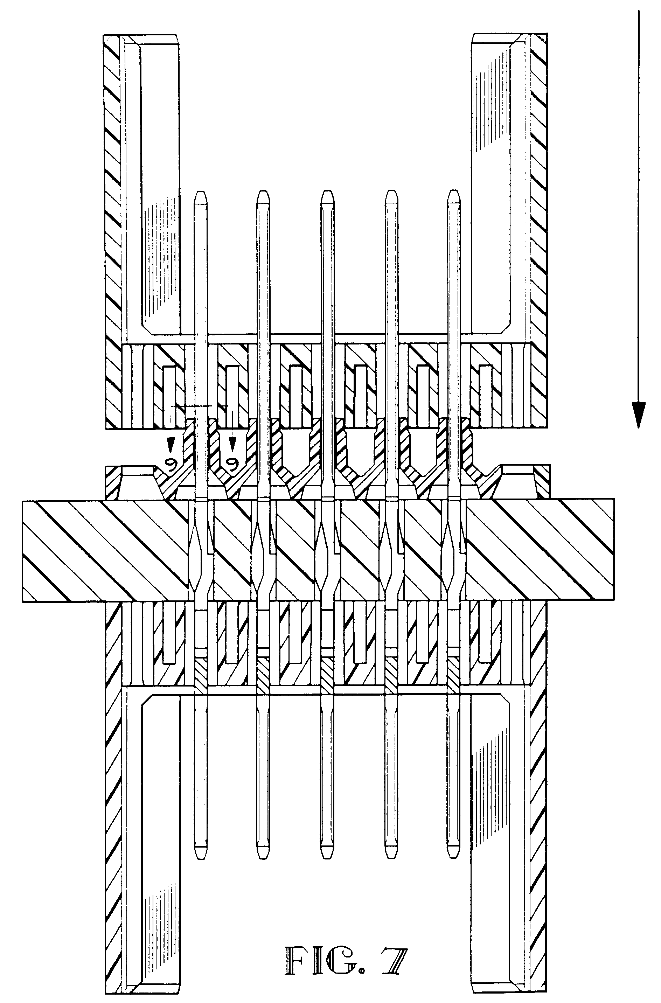

With the pin field 10 and the housing member 30 applied to the printed circuit board 12 as shown in Figure 1 and as described above, the housing member 40 can now be applied to the printed circuit board 12 by way of the locking spacer 42. The spacer member 42 can be attached to the housing member 40 as shown in Figure 1, and applied over the pin field 10 such that the lead in portions 48 are aligned with each of the pins at 10, and the spacer plate 42 can then be lowered until the surface 44 of the spacer member 42 abuts the surface 46 of the printed circuit board. It should be appreciated that, when in the position shown in Figure 7, there is little resistance between the retaining arms 54 and the pins 10, as the narrowed portions 56 of the retaining arms 54 provide little interference with the pins 10. This is best shown in Figure 9 where the outer tips 64 only contact the outer edges of the pin member 10. In the preferred embodiment of the invention, the pin is barrel shaped in cross-section, as shown in 10 to cooperate with the contact arms 54.

Further movement of the housing member 40 against the spacer plate 42 causes interference between the contact arms 54 and the pin member 10 by way of the enlarged sections 58 of the locking arms 54. This interference fit causes plastic material to flow around the edges of the pin 1 for example as shown at 84 in Figure 10. In this manner, the locking arms 54 are in gripping position against the roughened portions 26, to thereby retain the housings to the printed circuit board.

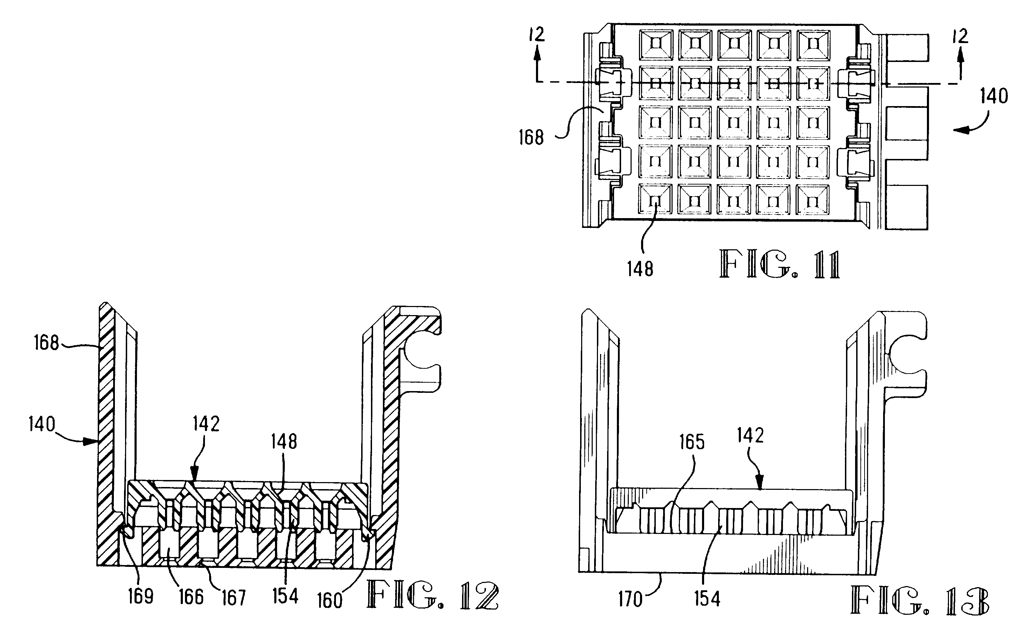

Referring now to Figures 11-13, which illustrate an embodiment of the present invention, the upper housing or header is shown as 140 having a locking plate 142, where the locking plate is positioned against the inside face 165 of the header 140. The locking plate 142 has latches 160 which are locked to corresponding shoulders 169 adjacent to the sidewalls 168. The locking plate 142 has locking arms 154 positioned within apertures 166 of the upper header 140 and operate in identical manner to locking arms 54 with respect to their corresponding apertures 66. The locking plate 142 is shown in its preassembled position in Figures 12 and 13, whereby the upper header 140 together with the locking plate 142 can be slidably received over the pin field 10 as shown in Figure 1, to a position where the lower face 170 abuts the surface 46 of the printed circuit board 12.

The latch arms 160 together with the corresponding locking shoulder 169 retain the locking plate 142 to the upper header 140 during the insertion of the pins 20 between the locking arms 154. The locking plate 142 can thereafter be pushed downwardly such that the locking arms 154 are cammed inwardly as discussed above, and grip the individual pin sections 20. This embodiment has a self-locking geometry whereby if the header 140 is pulled upwardly, the locking arms 154 will be forced further inwardly into the apertures 166 forming a tighter gripping arrangement between the locking arms and the corresponding pins 20.

Advantageously, then the present invention provides a way to attach a housing to a pin field. It is an advantage of the present invention that the housing may be attached without rubbing against the pins during insertion. It is another advantage that the present invention does not require epoxy or mechanical fasteners, such as screws, locking posts, etc. for retaining the housing to the board. The invention is especially advantageous for attaching opposing headers to a board.

## Claims

1. An electrical pin field comprising a printed circuit board (12) having a plurality of pins (10) extending between both sides thereof to position pin contact portions (20) on one side (46) of the board, a housing (140) mounted on the one side of the board, and a locking plate (142) positioned against the housing (140), the locking plate (142) having a plurality of through holes for receiving the pins (10) and at least one movable gripping arm (154) extending towards the housing (140) adjacent to each through hole and being an interference fit with a passageway (166) in the housing (140) and positioned against the pin (10), the passageways in the housing being positioned between the locking plate and the board.

2. The electrical pin field of claim 1, wherein a second housing (30) is positioned on the other side of the board (12).

3. The electrical pin field of claim 1 or 2, wherein each gripping arm has an arcuate surface (62) along its length facing the pin (10).

4. The electrical pin field of claim 1, 2 or 3, wherein the passageways (166) include camming surfaces for urging the gripping arms (154) into contact with the pins.

5. The electrical pin field of any one of the preceding claims, wherein the locking plate (142) is latchable to the housing (140) in a preassembled position, whereby the housing and the locking plate are joined together prior to engagement with the pins.

6. The electrical pin field of claim 5, wherein the locking plate (142) includes latches (160) and the housing (140) includes corresponding shoulders (169), the latches being latchable to the shoulders to retain the locking plate with the housing.

7. The electrical pin field of any one of the preceding claims, wherein the locking plate and the housing include camming surfaces of self-locking geometry, whereby the camming surfaces are adapted to tighten the gripping arm (154) upon a pin upon exertion of force upon the housing that would tend to separate the housing from the board.

8. The electrical pin field of any one of the preceding claims, wherein the gripping arms (154) include lead sections that interfere with the housing to laterally displace the arms into engagement with the pins.

## Patentansprüche

1. Elektrisches Stiftfeld, das folgendes umfaßt: eine Leiterplatte (12) mit mehreren Stiften (10), die sich zwischen deren beiden Seiten erstrecken, zum Positionieren von Stiftkontaktteilen (20) auf einer Seite (46) der Platine, ein auf der einen Seite der Platine montiertes Gehäuse (140), und eine an dem Gehäuse (140) positionierte Verriegelungsplatte (142), wobei die Verriegelungsplatte (142) mehrere Durchgangsöffnungen zur Aufnahme der Stifte (10) und mindestens einen beweglichen Greifarm (154), der in Richtung des Gehäuses (140) neben jeder Durchgangsöffnung verläuft und sich mit einem Durchgang (166) im Gehäuse (140) im Preßsitz befindet und an dem Stift (10) positioniert ist, aufweist, wobei die Durchgänge im Gehäuse zwischen der Verriegelungsplatte und der Platine positioniert sind.

2. Elektrisches Stiftfeld nach Anspruch 1, bei dem ein zweites Gehäuse (30) auf der anderen Seite der Platine (12) positioniert ist.

3. Elektrisches Stiftfeld nach Anspruch 1 oder 2, bei dem jeder Greifarm entlang seiner dem Stift (10) zugewandten Länge eine bogenförmige Fläche (62) aufweist.

4. Elektrisches Stiftfeld nach Anspruch 1, 2 oder 3, bei dem die Durchgänge (166) steuernde Flächen zum Drängen der Greifarme (154) in Kontakt mit den Stiften enthalten.

5. Elektrisches Stiftfeld nach einem der vorhergehenden Ansprüche, bei dem die Verriegelungsplatte (142) mit dem Gehäuse (140) in eine Vormontageposition gerastet werden kann, wodurch das Gehäuse und die Verriegelungsplatte vor dem Eingriff mit den Stiften miteinander verbunden werden.

6. Elektrisches Stiftfeld nach Anspruch 5, bei dem die Verriegelungsplatte (142) Rasten (160) enthält und das Gehäuse (140) entsprechende Schultern (169) enthält, wobei die Rasten an den Schultern eingerastet werden können, um die Verriegelungsplatte mit dem Gehäuse zu arretieren.

7. Elektrisches Stiftfeld nach einem der vorhergehenden Ansprüche, bei dem die Verriegelungsplatte und das Gehäuse steuernde Flächen mit selbstverriegelnder Geometrie enthalten, wodurch die steuernden Flächen ausgelegt sind, bei Anlegen von Kraft auf das Gehäuse, die im allgemeinen das Gehäuse von der Platine lösen würde, den Greifarm (154) an einem Stift festzuziehen.

8. Elektrisches Stiftfeld nach einem der vorhergehenden Ansprüche, bei dem die Greifarme (154) Führungsabschnitte enthalten, die mit dem Gehäuse interferieren, die Arme in Eingriff mit den Stiften seitlich auszulenken.

## Revendications

1. Réseau de broches électriques comprenant une carte à circuit imprimé (12) possédant une pluralité de broches (10) se prolongeant depuis les deux côtés de celle-ci pour positionner des portions de contact (20) des broches d'un côté (46) de la carte, un boîtier (140) monté de ce côté de la carte, et une plaque de blocage (142) positionnée contre le boîtier (140), la plaque de blocage (142) possédant une pluralité de trous traversants destinés à recevoir les broches (10) et au moins un bras de serrage mobile (154) se prolongeant vers le boîtier (140) à côté de chaque trou traversant et constituant un ajustement serré avec un passage (166) dans le boîtier (140) et positionné contre la broche (10), les passages dans le boîtier étant positionnés entre la plaque de blocage et la carte.

2. Réseau de broches électriques selon la revendication 1, dans lequel un deuxième boîtier (30) est positionné de l'autre côté de la carte (12).

3. Réseau de broches électriques selon la revendication 1 ou 2, dans lequel chaque bras de saisie présente une surface arquée (62) le long de sa longueur en regard de la broche (10).

4. Réseau de broches électriques selon la revendication 1, 2 ou 3, dans lequel les passages (166) comportent des surfaces de came destinées à pousser les bras de serrage (154) en contact avec les broches.

5. Réseau de broches électriques selon l'une quelconque des revendications précédentes, dans lequel la plaque de blocage (142) est susceptible de se verrouiller sur le boîtier (140) dans une position préassemblée, le boîtier et la plaque de blocage étant ainsi réunis avant l'engagement avec les broches.

6. Réseau de broches électriques selon la revendication 5, dans lequel la plaque de blocage (142) comporte des cliquets (160) et le boîtier (140) comporte des épaulements (169) correspondants, les cliquets étant susceptibles de se verrouiller sur les épaulements pour retenir la plaque de blocage avec le boîtier.

7. Réseau de broches électriques selon l'une quelconque des revendications précédentes, dans lequel la plaque de blocage et le boîtier comportent des surfaces de came présentant une géométrie d'auto-blocage, les surfaces de came étant ainsi adaptées pour serrer le bras de serrage (154) contre une broche lors de l'application d'une force sur le boîtier qui aurait tendance à séparer le boîtier de la carte.

8. Réseau de broches électriques selon l'une quelconque des revendications précédentes, dans lequel les bras de serrage (154) comportent des sections en plomb qui réalisent une interaction avec le boîtier afin de déplacer latéralement les bras pour qu'ils s'engagent avec les broches.
